# EUROPEAN PATENT SPECIFICATION

(11) **EP 4 074 650 B1**
(45) Date of publication and mention of the grant of the patent: **17.09.2025**
(21) Application number: 22165761.2
(22) Date of filing: 31.03.2022
(51) Int. Cl.: B81B 7/00

(54) **THIN FILM GETTER STRUCTURE HAVING MINIATURE HEATER AND MANUFACTURING METHOD THEREOF**
DÜNNFILM-GETTER-STRUKTUR MIT MINIATUR-HEIZUNG UND HERSTELLUNGSVERFAHREN DAFÜR
STRUCTURE GETTER À FILM MINCE DOTÉE D'UN CHAUFFAGE MINIATURE ET SON PROCÉDÉ DE FABRICATION

(30) Priority: 16.04.2021 CN 202110414599
(43) Date of publication of application: 19.10.2022
(73) Proprietor: Shanghai Industrial µ Technology Research Institute, Shanghai 201800 (CN)
(72) Inventor: Wang, Shinan, Shanghai, 201800 (CN); Lu, Tao, Shanghai, 201800 (CN)
(74) Representative: Gille Hrabal Partnerschaftsgesellschaft mbB Patentanwälte

(56) References cited:
- US-A1- 2012 228 733

## Description

### TECHNICAL FIELD

The present disclosure relates to the technical field of semiconductors, in particular to a thin film getter structure having miniature heater and a manufacturing method thereof.

### BACKGROUND

Some semiconductor devices, in particular some MEMS (Micro Electro Mechanical Systems) devices, need to be encapsulated in a vacuum environment to work. For example, for a MEMS acceleration sensor with a high-speed vibration component, a gyroscope or a vacuum gauge, a vibration part needs to be encapsulated in relatively stable vacuum. For another example, for a MEMS pressure sensor for which a vacuum chamber is needed, higher vacuum is needed in the vacuum chamber, and a vacuum degree keeps stable. Some infrared sensors also need encapsulate a device in a cavity having higher vacuum.

In one aspect, achieving higher vacuum encapsulation itself is challenging. The reason is: during encapsulation, there are often some residual gases detained in the vacuum chamber. Thus, it is often necessary to encapsulate a getter in the vacuum chamber, the getter is activated at the same time of encapsulation, or the getter is activated after completion of encapsulation, residual gases in the vacuum chamber are absorbed to realize higher vacuum required for device running. The getter is also called as a degasifier, and in the science and technology field of vacuum, refers to a material capable of effectively absorbing and fixing some or a kind of gas molecule. A gettering material generally has a porous structure. When active gas molecules collide with a clean surface of the gettering material, some gas molecules are absorbed, which is physical absorption of the gettering material, some gas molecules will have a chemical reaction with the gettering material to form a stable solid solution article, which is chemical absorption of the gettering material. And the gas molecules spread continuously to the interior of the material, thereby reaching a purpose of removing active gases in large quantities. Activating the getter often requires heating the getter at a high temperature with several hundred degrees. If an entire encapsulated device is heated from the outside, a MEMS device itself, an encapsulation method and a material must be able to withstand such high temperature, hence that is very constraining. In order to solve this problem, there is a technology in which the getter is coated on a resistance line, both ends of the resistance line are connected on a conductive terminal of an encapsulation housing, and after encapsulation, the getter is heated by electrifying the resistance line, so as to activate the getter.

The document US 2012 / 0228733 A relates to MEMS. It discloses the following: A MEMS getter microdevice enclosed in a hermetically sealed package, said package being disposed on a substrate, said MEMS getter microdevice being disposed on a portion of said substrate and comprising:
a platform suspended at a predetermined height above a top surface of said substrate, said platform being supported by at least one supporting leg, said at least one supporting leg having dimensions selected to provide low thermal conductance between said platform and said substrate;
a resistor element deposited on the top surfaces of said platform and of said at least one supporting legs, said resistor element being connected to electrical contact pads deposited on the top surface of said substrate, said resistor element providing heat when an electrical current is flowing through said resistor element;
a heat-spreading layer deposited on the top surface of said platform and covering the top surface of said resistor element; and a getter deposited in the form ofa thin film on a predetermined portion ofthe top surface of said heat-spreading layer, said thin-film getter having an activation temperature;
whereby said MEMS getter microdevice absorbs a portion of the gas species present in said package when said thin-film getter is heated at its activation temperature through electrical powering of said resistor element.

It should be noted that the above introduction to the technical background is just to facilitate a clear and complete description of the technical solutions of the present application, and is elaborated to facilitate the understanding of persons skilled in the art. It cannot be considered that the above technical solutions are known by persons skilled in the art just because these solutions are elaborated in the BACKGROUND of the present disclosure.

### SUMMARY

The inventor of the present disclosure considers that in a current getter structure with a heater, an activator is coated on a resistance line, often resulting in a larger volume, which is not suitable for a scene in which an encapsulation space is compact, and is not suitable for mass production either.

The embodiments of the present invention provide a thin film getter structure as defined in claim 1 having a miniature heater and a manufacturing method thereof as defined in claim 6. In the thin film getter structure, a getter thin film is provided on a surface of a heater, the heater has a laminated thin film structure, and a thickness of a thin film resistance of the heater is smaller, thereby a thickness of the thin film getter structure can be reduced, which is conducive to its miniaturization.

According to one aspect of the embodiments of the present invention, a thin film getter structure having a miniature heater is provided and comprises:
a substrate;
a heater formed at a side of a main face of the substrate; and
a getter thin film formed on a surface of the heater,
wherein the heater comprises:
   a first insulating thin film;
   a thin film resistance formed on an upper surface of the first insulating thin film; and
   a second insulating thin film covering the thin film resistance,
   both ends of the thin film resistance being electrodes exposed from the second insulating thin film, the second insulating thin film comprises a first portion (4a) and a second portion, the first portion and the second portion are separated from each other through an isolation groove,
   the first portion covers part of the thin film resistance.

According to another aspect of the embodiments of the present invention, a vacuum encapsulation structure of a micro-electro-mechanical system device is provided and comprises:
a vacuum encapsulation housing, the interior of which is formed as a vacuum chamber;
a micro-electro-mechanical system device encapsulated inside the vacuum encapsulation housing;
a conductive terminal, one end thereof being located inside the vacuum encapsulation housing, the other end thereof being located outside the vacuum encapsulation housing; and
the thin film getter structure according to said aspect of the embodiments, encapsulated inside the vacuum encapsulation housing,
wherein, an electrode of the thin film resistance of the thin film getter structure is electrically connected with the conductive terminal.

According to a further aspect of the embodiments of the present invention, a manufacturing method for a thin film getter structure having a miniature heater is provided and comprises:
forming a heater on a main face of a substrate; and
forming a getter thin film on a surface of the heater;
wherein, the step of forming the heater comprises:
forming a first insulating thin film on the main face of the substrate;
forming a thin film resistance on an upper surface of the first insulating thin film; and
forming a second insulating thin film covering the thin film resistance,
wherein, both ends of the thin film resistance are formed as electrodes exposed from the second insulating thin film,
the step of forming the heater further comprises:
   forming an isolation groove in the second insulating thin film, the isolation groove separates a first portion and a second portion of the second insulating thin film from each other,
   wherein, the first portion covers part of the thin film resistance.

An advantageous effect of the present disclosure lies in: in the thin film getter structure, a getter thin film is provided on a surface of a heater, the heater has a laminated thin film structure, and a thickness of a thin film resistance of the heater is smaller, thereby a thickness of the thin film getter structure can be reduced, which is conducive to its miniaturization.

Referring to the later description and figures, specific implementations of the present disclosure are disclosed in detail, indicating a manner that the principle of the present disclosure can be adopted. It should be understood that the implementations of the present disclosure are not limited in terms of the scope. Within the scope of the spirit and terms of the appended claims, the implementations of the present disclosure include many changes, modifications and equivalents.

Features that are described and/or shown with respect to one implementation can be used in the same way or in a similar way in one or more other implementations, can be combined with or replace features in the other implementations.

It should be emphasized that the term "comprise/include" when being used herein means the presence of a feature, a whole piece, a step or a component, but does not exclude the presence or addition of one or more other features, whole pieces, steps or components.

### DESCRIPTION OF FIGURES

The included figures are used to provide a further understanding on the embodiments of the present invention, constitute a part of the Description, are used to illustrate the implementations of the present disclosure, and expound the principle of the present disclosure together with the text description. Obviously, the figures in the following description are only some embodiments of the present invention. Persons skilled in the art can also obtain other figures based on these figures under the premise that they do not pay inventive labor. In the figures:
FIG. 1 is a schematic diagram of the getter structure provided in the present invention;
FIG. 2 is another schematic diagram of the getter structure provided in the present disclosure;
FIG. 3 is another schematic diagram of the getter structure provided in the present disclosure;
FIG. 4 is another schematic diagram of the getter structure provided in the present disclosure;
FIG. 5 is a schematic diagram of a processing method of the getter structure provided in the present disclosure;
FIG. 6 is another schematic diagram of a processing method of the getter structure provided in the present disclosure;
FIG. 7 is a schematic diagram of an application method of the getter structure provided in the present disclosure.

### DESCRIPTION OF IMPLEMENTATIONS

Referring to the figures, through the following Description, the above and other features of the present disclosure will become obvious. The Description and figures specifically disclose particular implementations of the present disclosure, showing partial implementations which can adopt the principle of the present application. It should be understood that the present disclosure is not limited to the described implementations, on the contrary, the present disclosure include all the modifications, variations and equivalents falling within the scope of the attached claims.

In the description of the following each embodiment of the present disclosure: the area refers to the area of a thin film in "a transverse direction", wherein "the transverse direction" represents a direction parallel to a surface of a substrate; "a longitudinal direction" represents a direction vertical to the surface of the substrate; in "the longitudinal direction", a direction pointing from a base to a heater is an "UP" direction, the direction opposite to the "UP" direction is a "DOWN" direction, the surface of each layer structure along the "UP" direction is "an upper surface", the surface opposite to "the upper surface" in each layer structure is "a lower surface". The settings on directions are just for convenience of describing the technical solutions of the present disclosure, and do not represent an orientation of a thin film getter structure or vacuum encapsulation structure when it is processed and used.

### EMBODIMENT 1

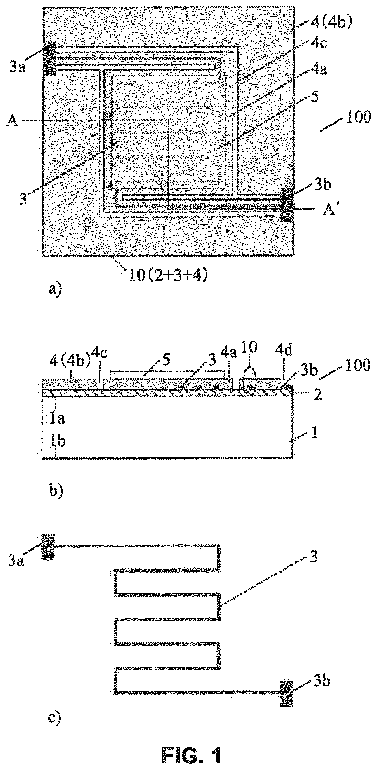

Embodiment 1 of the present invention provides a getter structure. The getter structure is provided with a heater. FIG. 1 is a schematic diagram of the present Embodiment. In the present Embodiment, in order to highlight the main idea of the present disclosure, the schematic diagram of FIG. 1 only includes the most basic elements. a) in FIG. 1 is a plane view of the getter structure 100, b) in FIG. 1 is a sectional view of the getter structure 100 which is cut open along the line marked by AA' in a) of FIG. 1, and c) of FIG. 1 is a plane view of a thin film resistance 3 of the getter structure 100.

As shown in a) of FIG. 1 and b) of FIG. 1, the getter structure 100 comprises: a substrate 1, and a heater 10 formed on a main face 1a of the substrate 1, and a getter thin film 5 formed on the heater 10. The heater 10 comprises a first insulating thin film 2 formed on the main face 1a of the substrate 1, a conductive thin film resistance 3 formed on the first insulating thin film 2, and a second insulating thin film 4 formed on the thin film resistance 3. A heat conductivity coefficient of the second insulating thin film 4 can be higher than that of the first insulating thin film 2, i.e., a heat conductivity capacity of the second insulating thin film 4 is better than that of the first insulating thin film 2. A second insulating thin film 4a covering a main portion of the conductive thin film resistance 3 is separated from a second insulating thin film 4b in remaining region, via an isolation groove 4c. Moreover, the area of a getter thin film 5 is smaller than the area of the second insulating thin film 4a. The overall area of the getter structure 100 is designed based on a gettering demand. For example, a surface of the getter structure 100 is a square shown in a) of FIG. 1, an edge length of an edge is about in a range of 0.5-5mm. In the present disclosure, the second insulating thin film 4a covering the main portion of the conductive thin film resistance 3 can be referred to as a first portion of the second insulating thin film 4a, the second insulating thin film 4b in remaining region can be referred to as a second portion of the second insulating thin film 4a.

The substrate 1 is provided with two corresponding main faces, i.e., a first main face 1a and a second main face 1b. The substrate 1 may be a commonly used wafer in the semiconductor manufacturing field, such as a silicon wafer, a Silicon On Insulator (SOI) wafer, a germanium silicon wafer, a germanium wafer or a gallium nitride wafer, a SiC wafer and the like, or may be an insulating wafer such as quartz, sapphire, glass and the like. In addition, the substrate 1 may also be a commonly used wafer in the semiconductor manufacturing field, a surface of the wafer is further provided with various thin films and various configurations required for a semiconductor device or a MEMS device. The present Embodiment has no limitation on this. A special example is the substrate 1 is a silicon substrate, with a thickness being about 700 micrometers and a diameter being about 200mm. Moreover, although in each embodiment of the present disclosure, the substrate 1 as a semiconductor substrate is taken as an example for description, the present disclosure is not limited to this, the substrate 1 can be also replaced with a non-semiconductor substrate. In addition, in Embodiment 1 and the following Embodiment 3 and Embodiment 5, the substrate 1 is preferably an insulating substrate, such as a glass substrate and the like.

A material and thickness of the first insulating thin film 2 formed on the main face 1a of the substrate 1 are designed according to a heater performance need. There are two main functions. One is to realize electric insulation between the conductive thin film resistance 3 and the substrate 1. Two is to realize thermal insulation between the thin film resistance 3 and the substrate 1, so that heat produced by the thin film resistance 3 after being electrified effectively flows to a direction of the getter thin film 5. For example, if thermal insulativity of the substrate 1 is not sufficient enough, thermal insulativity of the first insulating thin film 2 needs to be sufficiently higher than the thermal insulativity of the substrate 1. The first insulating thin film 2 may be a thin film composed of a single material, or may be a composite thin film composed of multiple materials, or may be a composite thin film formed by thin film stacks of plural single materials. For example, the first insulating thin film 2 is a single thin film composed of an oxide of silicon. A thickness of the first insulating thin film 2 e.g. is 0.1-2 micrometers.

The function of the thin film resistance 3 is to produce a high enough temperature after it is electrified, to activate the getter thin film 5. Thus, a material, a shape, etc. of the thin film resistance 3 can be designed based on a demand of activating the getter thin film 5. A material of the thin film resistance 3 must be able to withstand a temperature required for activating the getter thin film 5, a magnitude of its resistance must be suitable for producing a high enough temperature when it is properly electrified, to activate the getter thin film 5. The material of the thin film resistance 3 may be a metal. For example, the material of the thin film resistance 3 is a metal containing one or more of Pt, W, Au, Al, Cu, Ni, Ta, Ti, Cr. The material of the thin film resistance 3 may be a semiconductor. For example, the material of the thin film resistance 3 is polycrystalline silicon. When the material of the thin film resistance 3 is polycrystalline silicon, the polycrystalline silicon can be doped based on a need, so as to regulate its electric conductivity. The material of the thin film resistance 3 may also be a metallic compound. For example, the material of the thin film resistance 3 is TiN, TaAlN. A thickness of the thin film resistance 3 e.g. is 0.1-1 micrometer. The thin film resistance 3 may be a continuous thin film, or may be a graphic thin film as shown in a), b, c of FIG. 1. For example, the thin film resistance 3 is a thin film having a fold line shape as shown in the plane view of c) of FIG. 1. Electrodes 3a and 3b of the thin film resistance 3 are exposed via a window 4d opened on the second insulating thin film 4, so as to connect an external power source (not shown), for example two ends of the thin film resistance 3 are the electrodes 3a and 3b exposed from the second insulating thin film 4.

A material and thickness of the second insulating thin film 4 formed on the thin film resistance 3 are designed according to a heater performance need. There are three main functions. One is to realize electric insulation between the conductive thin film resistance 3 and the getter thin film 5. Two is to gather heat produced by the thin film resistance 3 and conduct the heat to the getter thin film 5, so that a temperature of the getter thin film 5 reaches its activation temperature. Three is to evenly conduct heat produced by the thin film resistance 3 to the getter thin film 5. A heat conduction capacity of the second insulating thin film 4 is better than that of the first insulating thin film 2, which is conducive to effectively conduct heat produced by the thin film resistance 3 after being electrified to the getter thin film 5. The second insulating thin film 4 may be a thin film composed of a single material, or may be a composite thin film composed of multiple materials, or may be a composite thin film formed by thin film stacks of plural single materials. For example, the first insulating thin film 2 is a single thin film composed of an oxide of silicon, the second insulating thin film 4 is a single thin film composed of a nitride of silicon. At this moment, film growth conditions of the first insulating thin film 2 and the second insulating thin film 4 are adjusted, so that heat conduction of the second insulating thin film 4 is higher than that of the first insulating thin film 2. A thickness of the second insulating thin film 4 e.g. is 0.1-2 micrometers. A second insulating thin film 4a covering a main portion of the conductive thin film resistance 3 is separated from a second insulating thin film 4b in remaining region, via an isolation groove 4c, so that heat produced by the thin film resistance 3 is effectively conducted to the getter thin film 5. The isolation groove 4c is a channel formed on the second insulating thin film 4, the channel penetrates through upper and lower surfaces of the second insulating thin film 4 to reach a surface of the underneath first insulating thin film 2. The isolation groove 4c is formed at a periphery of the thin film resistance 3.

The first insulating thin film 2, the thin film resistance 3 formed on the first insulating thin film 2, and the second insulating thin film 4 formed on the thin film resistance 3 form a heater 10.

The getter thin film 5 formed on the heater 10 is composed of a getter material. A material, area and thickness of the getter thin film 5 are designed based on factors such as a type and amount of a gas to be adsorbed. The area of the getter thin film 5 is smaller than the area of the second insulating thin film 4a, so that the getter thin film 5 can be effectively activated via the second insulating thin film 4a. For example, the getter thin film 5 may be a Zr-base non-evaporable getter, including a material such as ZrVFe, ZrAl, ZrC and the like. The getter thin film 5 may be a Ti-base non-evaporable getter, including a material such as Ti-Mo and the like. A size, proportion, etc. of a pore of the getter thin film 5 can be adjusted properly. For example, a percentage of a pore of the getter thin film 5 is above 40%. A thickness of the getter thin film 5 e.g. is about 0.1-5 micrometers.

The getter structure 100 as described above can enable a maximum temperature reached by the getter thin film 5 during activation to be 200°C-1000°C. An overall optimization design on the getter structure 100, in particular a design on the heater 10, can be carried out based on an actually needed activation temperature. For a thin film structure composed of the heater 10 and the getter thin film 5, an overall stress of the thin film needs to be properly considered in the design, so that the getter structure 100 will not be damaged due to the stress during manufacturing and use.

Moreover, in some implementations of the present invention, a surface of the substrate 1 can have a concave cavity which can be located at a lower side of a heater, thereby heat produced by the heater can be transferred to the getter thin film 5 more intensively, to improve the efficiency of heating the getter thin film.

As described above, this Embodiment provides a thin film getter structure having a smaller volume and with a heater. Such structure can reduce occupation of a volume of a micro vacuum chamber. Such structure has better mass productivity because it can be processed by using a semiconductor process. In addition, because the thin film getter structure in this embodiment is provided with a heater, the thin film getter structure in this embodiment can activate a thin film getter at any time when needed, effectively adsorb a gas increasing with time in the vacuum chamber, and extend a service life of a MEMS device sealed together in the vacuum chamber.

### EMBODIMENT 2

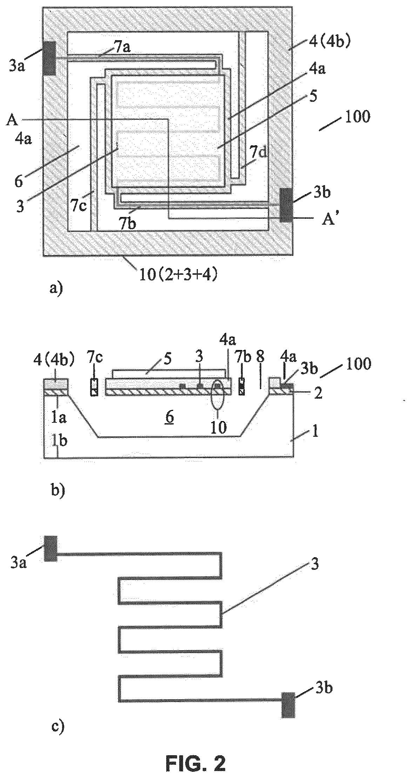

Embodiment 2 of the present invention provides another getter structure. The getter structure is provided with a heater. FIG. 2 is a schematic diagram of the present Embodiment. In the present Embodiment, in order to highlight the main idea of the present disclosure, the schematic diagram of FIG. 2 only includes the most basic elements. a) in FIG. 2 is a plane view of the getter structure 100, b) in FIG. 2 is a sectional view of the getter structure 100 which is cut open along the line marked by AA' in a) of FIG. 2, and c) of FIG. 2 is a plane view of a thin film resistance 3 of the getter structure 100. For the sake of clarity, the contents similar to those in Embodiment 1 will not be described in detail in the present Embodiment.

As shown in a) of FIG. 2 and b) of FIG. 2, the getter structure 100 comprises: a substrate 1, and a heater 10 formed on a main face 1a of the substrate 1, and a getter thin film 5 formed on the heater 10. The heater 10 comprises a first insulating thin film 2 formed on the main face 1a of the substrate 1, a conductive thin film resistance 3 formed on the first insulating thin film 2, and a second insulating thin film 4 formed on the thin film resistance 3. A heat conductivity capacity of the second insulating thin film 4 is better than that of the first insulating thin film 2. Moreover, the area of a getter thin film 5 is smaller than the area of the second insulating thin film 4a. The overall area of the getter structure 100 is designed based on a gettering demand. For example, a surface of the getter structure 100 is a square shown in FIG. 1a, an edge length of an edge is about in a range of 0.5-5mm. Different from Embodiment 1, in the present Embodiment 2, the substrate 1 below the heater 10 has a cavity 6. Namely, a main portion of the heater 10 (i.e., a portion bearing the getter thin film 5) is suspended above the cavity 6, and is supported on a main face of the substrate 1 surrounding the cavity 6 via a connection part. The connection part e.g. is a cantilever beam 7 (for example including 7a, 7b, 7c, 7d), the cantilever beam 7 can be connected to the main face 1a of the substrate 1. The cantilever beam 7 can have two branches, or can have more than two branches. For example, in the present Embodiment, the cantilever beam 7 has four branches containing 7a, 7b, 7c, 7d. In such structure, the main portion of the heater 10 and the getter thin film 5 are separated from the remaining region, and are connected only via the cantilever beam 7. In this way, heat produced by electrifying the thin film resistance 3, in terms of solid conduction, only has a loss produced via the cantilever beam 7. By appropriately designing a width, a length and a thickness of the cantilever beam, a solid conduction heat loss produced via the cantilever beam 7 can become small enough. The result is that compared with Embodiment 1, the getter structure 100 of the present Embodiment will conduct heat produced by a heater onto the getter thin film 5 more intensively, which improves the heating efficiency required to activate the getter thin film 5 and has effects of saving heating energy and increasing a maximum heating temperature.

The substrate 1 is provided with two corresponding main faces, i.e., a first main face 1a and a second main face 1b. The substrate 1 can be the same as the substrate 1 in the Embodiment 1.

A material and thickness of the first insulating thin film 2 formed on the main face 1a of the substrate 1 are designed according to a heater performance need. The first insulating thin film 2 can be the same as the first insulating thin film 2 in the Embodiment 1.

The thin film resistance 3 formed on the first insulating thin film 2 can be designed based on a demand of activating the getter thin film 5. The thin film resistance 3 can be the same as the thin film resistance 3 in the Embodiment 1. For example, the thin film resistance 3 is a thin film having a fold line shape as shown in the plane view of c) of FIG. 2. One end of the thin film resistance 3 is connected with the electrode 3a via the cantilever beam 7a, and the other end of the thin film resistance 3 is connected with the electrode 3b via the cantilever beam 7b. Electrodes 3a and 3b of the thin film resistance 3 are exposed via a window 4d opened on the second insulating thin film 4, so as to connect an external power source (not shown).

A material and thickness of the second insulating thin film 4 formed on the thin film resistance 3 are designed according to a heater performance need. The function of the second insulating thin film 4 is the same as that in Embodiment 1. The second insulating thin film 4 can be the same as the second insulating thin film 4 in the Embodiment 1.

The first insulating thin film 2, the thin film resistance 3 formed on the first insulating thin film 2, and the second insulating thin film 4 formed on the thin film resistance 3 form a heater 10.

The getter thin film 5 formed on the heater 10 is composed of a getter material. A material, area and thickness of the getter thin film 5 are designed based on factors such as a type and amount of a gas to be adsorbed. The area of the getter thin film 5 is smaller than the area of the second insulating thin film 4a, so that the getter thin film 5 can be effectively activated via the second insulating thin film 4a. The getter thin film 5 can be the same as the getter thin film 5 in the Embodiment 1.

For a thin film structure composed of the heater 10 and the getter thin film 5, an overall stress needs to be properly considered in the design, so that the getter structure 100 in particular the cantilever beam 7 the will not be damaged due to the stress during manufacturing and use. The cantilever beam 7 needs to have an enough strength to support a thin film structure composed of the heater 10 and the getter thin film 5, so that the thin film structure can suspend better.

As described above, this Embodiment provides another thin film getter structure having a smaller volume and with a heater. Besides the effect of Embodiment 1, such structure further has the following effect. Namely, in such structure, the main portion of the heater 10 and the getter thin film 5 are connected with the remaining region only via the cantilever beam 7, so that a loss of heat produced by electrifying the thin film resistance 3 due to solid conduct becomes small enough. The result is that the getter structure of the present Embodiment will conduct heat produced by a heater onto the getter thin film more intensively, which improves the heating efficiency required to activate the getter thin film and has effects of saving heating energy and increasing a maximum heating temperature.

### EMBODIMENT 3

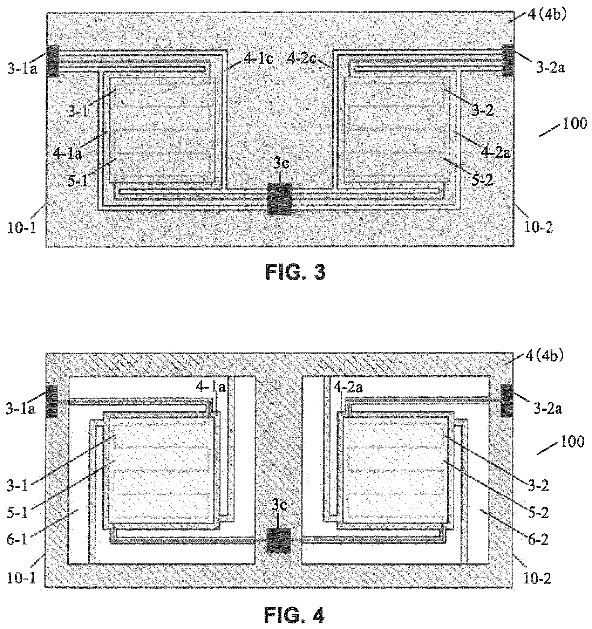

Embodiment 3 of the present invention provides a getter structure. The getter structure is provided with a MEMS heater. FIG. 3 is a plan schematic diagram of the present Embodiment. In the present Embodiment, in order to highlight the main idea of the present disclosure, the schematic diagram of FIG. 3 only includes the most basic elements. For a content in the present Embodiment 3 similar to the above Embodiment 1, Embodiment 1 can be referred to, no detailed description will be made here.

The characteristic of the Embodiment 3 is: the getter structure 100 has two or more getter structural units composed of the heater 10 and the getter thin film 5 formed thereon. For example, as shown in FIG. 3, the getter structure 100 has two getter structural units. Each getter structural unit has a structure similar to the getter structure 100 of Embodiment 1. A getter thin film 5-1 of the first getter structural unit corresponds to a heater 10-1, a getter thin film 5-2 of the second getter structural unit corresponds to a heater 10-2. The heater 10-1 and the heater 10-2 can be completely independent. However, in order to save power source input terminals, the heater 10-1 and the heater 10-2 can share an electrode 3c. Such structure enables the heater 10-1 to be electrified independently via the electrode 3-1a and the electrode 3c, and enables the heater 10-2 to be electrified independently via the electrode 3-2a and the electrode 3c. Namely, the getter thin film 5-1 and the getter thin film 5-2 can be independently activated respectively by heating.

Two or more getter structural units composed of the heater 10 and the getter thin film 5 formed thereon are integrated on a substrate, so that a volume of the getter structure 100 is compact, and a precious space of a micro vacuum chamber can be saved. In addition, because the thin film getter structure with two or more heaters which can be activated independently can respectively activate an independent thin film getter at different time points and can effectively absorb a gas increasing with time in a vacuum chamber, compared with a structure having a getter structural unit, the thin film getter structure can further extend a service life of a MEMS device sealed together in the vacuum chamber.

### EMBODIMENT 4

Embodiment 4 of the present invention provides another getter structure. The getter structure is provided with a MEMS heater. FIG. 4 is a plan schematic diagram of the present Embodiment. In the present Embodiment, in order to highlight the main idea of the present disclosure, the schematic diagram of FIG. 4 only includes the most basic elements. For a content in the present Embodiment 4 similar to the above Embodiments 2 and 3, Embodiments 2 and 3 can be referred to, no detailed description will be made here.

The characteristic of the Embodiment 4 is: the getter structure 100 has two or more getter structural units composed of the heater 10 and the getter thin film 5 formed thereon. For example, as shown in FIG. 4, the getter structure 100 has two getter structural units. Each getter structural unit has a structure similar to the getter structure 100 of Embodiment 2. A getter thin film 5-1 of the first getter structural unit corresponds to a heater 10-1, a getter thin film 5-2 of the second getter structural unit corresponds to a heater 10-2. The heater 10-1 and the heater 10-2 can be completely independent. However, in order to save power source input terminals, the heater 10-1 and the heater 10-2 can share an electrode 3c. Such structure enables the heater 10-1 to be electrified independently via the electrode 3-1a and the electrode 3c, and enables the heater 10-2 to be electrified independently via the electrode 3-2a and the electrode 3c. Namely, the getter thin film 5-1 and the getter thin film 5-2 can be independently activated respectively by heating.

The getter structure of the present Embodiment combines the effects of Embodiment 2 and Embodiment 3, can respectively activate an independent thin film getter more effectively at different time points, and extend a service life of a MEMS device sealed together in a vacuum chamber.

### EMBODIMENT 5

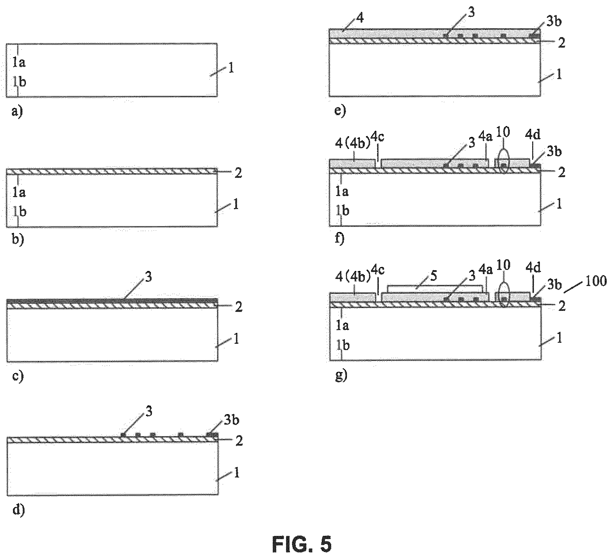

Embodiment 5 of the present invention provides a manufacturing method of a getter structure. FIG. 5 is a section schematic diagram of the present Embodiment. The getter structure of Embodiment 1 described in FIG. 1 and the getter structure of Embodiment 3 described in FIG. 3 can be manufactured by using the manufacturing method of the present Embodiment. In the present Embodiment, in order to highlight the main idea of the present disclosure, the schematic diagram of FIG. 5 only includes the most basic elements. For an identical content with Embodiments 1 and 3 in terms of a configuration, material, etc. involved in the present Embodiment 5, Embodiments 1 and 3 can be referred to, no detailed description will be made here. For the sake of clarity, in the present Embodiment 5, the getter structure 100 of Embodiment 1 is taken as an example to describe the manufacturing method.

The manufacturing method of the getter structure 100 provided by the present Embodiment 5 comprises: forming the heater 10 on the main face 1a of the substrate 1, and forming a getter thin film 5 on the heater 10. A manufacturing method of the heater 10 comprises: forming a first insulating thin film 2 on the main face 1a of the substrate 1, forming a conductive thin film resistance 3 on the first insulating thin film 2, and forming a second insulating thin film 4 on the thin film resistance 3. And, the second insulating thin film 4 is processed, so that a second insulating thin film 4a covering a main portion of the thin film resistance 3 is separated from a second insulating thin film 4b in remaining region. The manufacturing method is described step by step as follows.

Firstly, as shown in a) of FIG. 5, preparing the substrate 1. In the present Embodiment, the substrate 1 is provided with two corresponding main faces, i.e., a first main face 1a and a second main face 1b. The substrate 1 can be the substrate 1 described in the Embodiment 1. For the sake of simplicity and convenience, in the present Embodiment, description is made by taking the substrate 1 being a Si substrate conventionally used in a semiconductor process as an example.

Then, as shown in b) of FIG. 5, forming a first insulating thin film 2 on the main face 1a of the substrate 1. The first insulating thin film 2 is the first insulating thin film 2 described in the Embodiment 1. For example, the first insulating thin film 2 is a silox thin film, has a thickness being 0.3 micrometer, and is formed by using conventional TEOS CVD (TEOS: Tetraethylorthosilicate, " 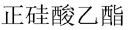 " in Chinese. CVD: Chemical Vapor Deposition, " 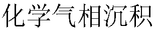 " in Chinese) and a matched process.

Then, as shown in c) of FIG. 5, forming a conductive thin film resistance 3 on the first insulating thin film 2. The conductive thin film resistance 3 is the conductive thin film resistance 3 described in the Embodiment 1. For example, the conductive thin film resistance 3 is a metal W, has a thickness being 0.2 micrometer, and is formed by using conventional magnetron sputtering and a matched process.

Then, as shown in d) of FIG. 5, processing the conductive thin film resistance 3, and forming a fold-line shaped conductive thin film resistance 3 as shown in FIG. 1c, and electrodes 3a and 3b at two ends. Processing the conductive thin film resistance 3 can be carried out by using conventional photoetching and metal etching and a matched process. For example, an Ion Beam Etching (IBE) method can be used for a metal etching process.

Then, as shown in e) of FIG. 5, forming a second insulating thin film 4 on the thin film resistance 3. The second insulating thin film 4 is the second insulating thin film 4 described in the Embodiment 1. For example, the second insulating thin film 4 is a silicon nitride thin film, has a thickness being 0.4 micrometer, and film growth is performed by using conventional PECVD (PECVD: Plasma Enhanced Chemical Vapor Deposition, " 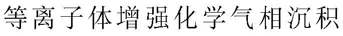 " in Chinese).

Then, as shown in f) of FIG. 5 and a) of FIG. 1, processing the second insulating thin film 4, and forming the isolation groove 4c and the window 4d. Processing the second insulating thin film 4 can be carried out by using conventional photoetching and silicon nitride etching and a matched process. The isolation groove 4c is a channel formed on the second insulating thin film 4, the channel penetrates through upper and lower surfaces of the second insulating thin film 4 to reach a surface of the underneath first insulating thin film 2. The isolation groove 4c is formed at the periphery of the thin film resistance 3, so that a second insulating thin film 4a covering a main portion of the conductive thin film resistance 3 is separated from a second insulating thin film 4b in remaining region, via the isolation groove 4c. The window 4d is a window formed on the second insulating thin film 4, the window penetrates through upper and lower surfaces of the second insulating thin film 4 to reach surfaces of the underneath electrodes 3a and 3b.

Through the processing as shown in b) of FIG. 5 to f) of FIG. 5, forming the heater 10 composed of the first insulating thin film 2, the conductive thin film resistance 3 formed on the first insulating thin film 2, and the second insulating thin film 4a covering a main portion of the conductive thin film resistance 3.

Then, as shown in g) of FIG. 5, forming the getter thin film 5 on the heater 10. The getter thin film 5 is the getter thin film 5 described in the Embodiment 1. The area of the getter thin film 5 is smaller than the area of the second insulating thin film 4a. For example, the getter thin film 5 is a Zr-base non-evaporable getter material including ZrVFe, and has a thickness being about 2 micrometers. The getter thin film 5 can be deposited above the second insulating thin film 4a by using a magnetron sputtering method. During deposition of the getter thin film 5, a metal mask (not shown) can be covered on a surface of a substrate for which the processing as shown in f) of FIG. 5 is completed. A window is opened at a part of the metal mask with respect to the getter thin film 5 as shown in g) of FIG. 5, so that at the time of magnetron sputtering, the getter thin film 5 can be deposited above the second insulating thin film 4a via the window. An advantage of using metal mask is: there is no need to perform etching processing for the getter thin film 5, to avoid possible contaminations to the getter thin film 5 during etching processing. Another advantage of using metal mask is: a process of forming the getter thin film 5 is simple, a metal mask can be used repeatedly, the manufacturing cost is reduced.

Obviously, by using the manufacturing method of the getter structure 5 as described in FIG. 5, not only the getter structure 5 of a signal unit as shown in Embodiment 1 can be manufactured, but also it is suitable for manufacturing the getter structure 5 of plural units as shown in Embodiment 3.

As described above, the present Embodiment provides a manufacturing method of a getter structure, which is suitable for manufacturing the getter structures as shown in Embodiment 1 and Embodiment 3. The manufacturing method is simple, and the manufacturing cost is low. On a semiconductor substrate, plural getter structures can be manufactured simultaneously, there is mass productivity.

### EMBODIMENT 6

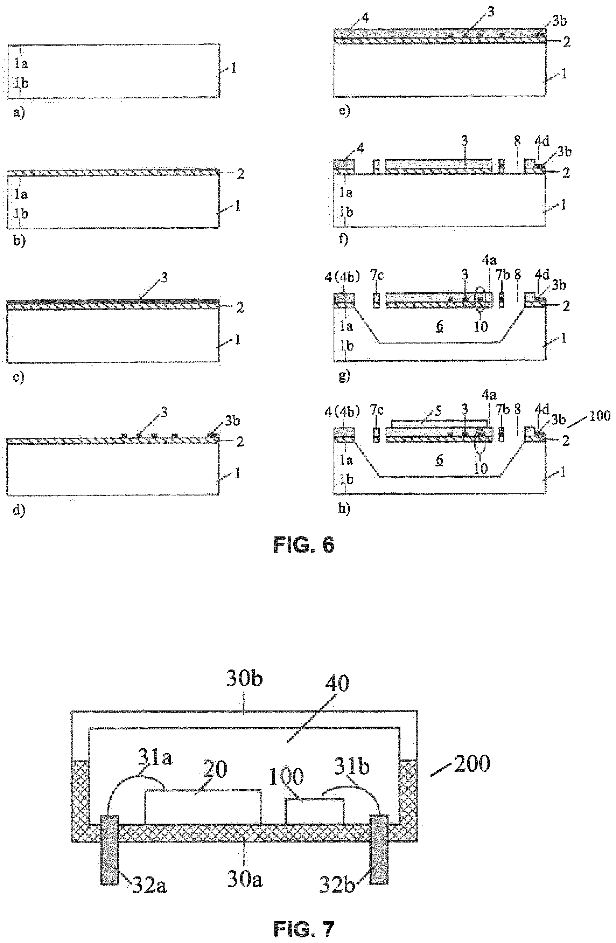

Embodiment 6 of the present invention provides another manufacturing method of a getter structure. FIG. 6 is a section schematic diagram of the present Embodiment. The getter structure 100 of Embodiment 2 described in FIG. 2 and the getter structure 100 of Embodiment 4 described in FIG. 4 can be manufactured by using the manufacturing method of the present Embodiment. In the present Embodiment, in order to highlight the main idea of the present disclosure, the schematic diagram of FIG. 6 only includes the most basic elements. For an identical content with Embodiments 2 and 4 in terms of a configuration, material, etc. involved in the present Embodiment 6, Embodiments 2 and 4 can be referred to, no detailed description will be made here. For the sake of simplicity, in the present Embodiment 6, it is in common use with the Embodiment 5, no detailed introduction is made here. For the sake of clarity, in the present Embodiment 6, the getter structure 100 of Embodiment 2 is taken as an example to describe the manufacturing method.

The manufacturing method of the getter structure 100 provided by the present Embodiment 6 comprises: forming the heater 10 on the main face 1a of the substrate 1, and forming a getter thin film 5 on the heater 10. Moreover, the manufacturing method further comprises: before forming the getter thin film 5 on a surface of a heater, etching the heater 10 to form a connection part and a pattern of a part of the heater for bearing the getter thin film 5, and etching the main face 1a of the substrate 1, so that the part of the heater 10 for bearing the getter thin film is suspended, for example: processing the heater 10 and the substrate 1, so that cavities are formed under the heater 10, and are connected with the substrate 1 via the cantilever beam 7 (including 7a, 7b, 7c, 7d). The manufacturing method is described step by step as follows.

Firstly, as shown in a) of FIG. 6, preparing the substrate 1. In the present Embodiment, the substrate 1 is provided with two corresponding main faces, i.e., a first main face 1a and a second main face 1b. The substrate 1 is the substrate 1 described in the Embodiment 2. For the sake of simplicity and convenience, in the present Embodiment, description is made by taking the substrate 1 being a Si substrate conventionally used in a semiconductor process as an example.

Then, as shown in b) of FIG. 6, forming a first insulating thin film 2 on the main face 1a of the substrate 1. The first insulating thin film 2 is the first insulating thin film 2 described in the Embodiment 2. For example, the first insulating thin film 2 is a silox thin film, has a thickness being 0.4 micrometer, and is formed by using conventional TEOS CVD and a matched process.

Then, as shown in c) of FIG. 6, forming a conductive thin film resistance 3 on the first insulating thin film 2. The conductive thin film resistance 3 is the conductive thin film resistance 3 described in the Embodiment 2. For example, the conductive thin film resistance 3 is a metal Pt, has a thickness being 0.2 micrometer, and is formed by using a conventional magnetron sputtering process.

Then, as shown in d) of FIG. 6, processing the conductive thin film resistance 3, and forming a fold-line shaped conductive thin film resistance 3 as shown in c) of FIG. 2, and electrodes 3a and 3b at two ends. Conventional photoetching and Ion Beam Etching method are adopted for processing of the conductive thin film resistance 3.

Then, as shown in e) of FIG. 6, forming a second insulating thin film 4 on the thin film resistance 3. The second insulating thin film 4 is the second insulating thin film 4 described in the Embodiment 2. For example, the second insulating thin film 4 is a silicon nitride thin film, has a thickness being 0.4 micrometer, and film growth is performed by using a conventional PECVD mode.

Then, as shown in f) of FIG. 6 and a) of FIG. 2, processing the second insulating thin film 4 and the first insulating thin film 2 at a lower part of the second insulating thin film 4, and forming the channel 8 and the window 4d. Forming the channel 8 to penetrate through the second insulating thin film 4 and the first insulating thin film 2 at a lower part of the second insulating thin film 4 in a depth direction, and exposing the first main face 1a of the substrate at the bottom. The window 4d penetrates the second insulating thin film 4 in the depth direction, surfaces of the electrodes 3a and 3b are exposed at the bottom. Processing of the second insulating thin film 4 and the first insulating thin film 2 at a lower part of the second insulating thin film 4 can be carried out separately, or can be carried out continuously. When such processing is carried out separately, after etching the second insulating thin film 4 by using conventional photoetching and silicon nitride etching and a matched process, photoetching is performed again and the first insulating thin film 2 is etched by using silicon oxide etching and a matched process. When such processing is carried out continuously, conventional photoetching can be performed only once, then the second insulating thin film 4 and the first insulating thin film 2 are etched continuously by using dry etching and a matched process.

Then, as shown in g) of FIG. 6 and a) of FIG. 2, processing the substrate 1, forming the cavity 6 under the heater 10, meanwhile forming the cantilever beam 7 (including 7a, 7b, 7c, 7d). In this way, the heater 10 is suspended in the air and is connected with the substrate 1 only via the cantilever beam 7. Processing the substrate 1 can be performed by using a conventional silicon processing process. For example, silicon is etched by using a gas or plasma which has an etching function on silicon. At this moment, the gas or plasma reaches a surface of the substrate 1 via the channel 8 to perform etching. The gas e.g. is XeF2, or SF6, etc. The plasma e.g. is a plasma such as SF6, etc. For another example, silicon is etched by using a liquid which has an etching function on silicon. At this moment, the liquid also reaches a surface of the substrate 1 via the channel 8 to perform etching. The liquid e.g. is KOH, TMAH, etc.

Through the processing as shown in b) of FIG. 6 to g) of FIG. 6, forming the heater 10 composed of the first insulating thin film 2, the conductive thin film resistance 3 formed on the first insulating thin film 2, and the second insulating thin film 4a covering a main portion of the conductive thin film resistance 3. The heater 10 is suspended in the air and is connected with the substrate 1 only via the cantilever beam 7.

Then, as shown in h) of FIG. 6 and a) of FIG. 2, forming the getter thin film 5 on the heater 10. The getter thin film 5 is the getter thin film 5 described in the Embodiment 2. The area of the getter thin film 5 is smaller than the area of the second insulating thin film 4a. For example, the getter thin film 5 is a Ti-base non-evaporable getter material including Ti-Mo, and has a thickness being about 2 micrometers. The getter thin film 5 can be deposited above the second insulating thin film 4a by using a magnetron sputtering method of a metal mask as described in Embodiment 5.

Obviously, by using the manufacturing method of the getter structure 6 as described in FIG. 5, not only the getter structure 5 of a signal unit as shown in Embodiment 2 can be manufactured, but also it is suitable for manufacturing the getter structure 5 of plural units as shown in Embodiment 4.

As described above, the present Embodiment provides aother manufacturing method of a getter structure, which is suitable for manufacturing the getter structures as shown in Embodiment 2 and Embodiment 4. The manufacturing method is simple, and the manufacturing cost is low. On a semiconductor substrate, plural getter structures can be manufactured simultaneously, there is mass productivity.

### EMBODIMENT 7

Embodiment 7 of the present invention provides a vacuum encapsulation structure of a MEMS device. FIG. 7 is a section schematic diagram of the present Embodiment. In the present Embodiment, in order to highlight the main idea of the present disclosure, the schematic diagram of FIG. 7 only includes the most basic elements

As shown in FIG. 7, the vacuum encapsulation structure 200 of the MEMS device in the embodiments of the present disclosure comprises: a vacuum encapsulation housing 30 (including 30a and 30b), a conductive terminal 32 (including 32a, 32b) connected with interior and exterior of the vacuum encapsulation housing 30b, a MEMS device 20 encapsulated in the vacuum encapsulation housing 30, and a getter structure 100. Electrodes (not shown) of the getter structure 100 are electrically connected via a wire 31b and the conductive terminal 32b. A vacuum chamber 40 is formed inside the vacuum encapsulation housing 30.

The vacuum encapsulation housing 30 consists of the housing 30a, the housing 30b, and the conductive terminal 32 (including 32a, 32b) communicating with interior and exterior of the vacuum encapsulation housing 30b. The vacuum encapsulation housing 30 is a standard component adopted for a semiconductor device or MEMS device vacuum encapsulation, inside which the vacuum chamber 40 is formed after encapsulation. An initial vacuum degree of the vacuum chamber 40 conforms to a vacuum degree required for the MEMS device 20 to run normally. The number of the conductive terminals 32a is plural, they are respectively connected with each electrode of the MEMS device 20. The number of the conductive terminals 32b is plural, they are respectively connected with each electrode of the getter structure 100.

The MEMS device 20 is a MEMS device that needs to work in a certain vacuum atmosphere. For example, the MEMS device 20 may be one or more of the following MEMS devices: a MEMS oscillator, a MEMS pressure sensor, a MEMS resonant filter, a MEMS inertial sensor (a MEMS gyroscope and a MEMS accelerometer, etc.), a MEMS infrared imaging device and the like. Each electrode of the MEMS device 20 is electrically connected respectively with different conductive terminals 32a via different wires 31a.

The getter structure 100 is one of the getter structures 100 described in the Embodiments 1-4. The number of the getter structures 100 may be one, or may be plural. Each getter structure 100 may comprise the single getter structural unit as shown in the Embodiments 1 and 3, and may also comprise the plural getter structural units as shown in the Embodiments 2 and 4. Each electrode of the getter structure 100 is electrically connected respectively with different conductive terminals 32b via different wires 31b.

At least one getter structural unit of the getter structure 100 can be activated immediately after completion of encapsulation in the vacuum encapsulation structure 200, absorb gases residual in the vacuum chamber 40, and enable the vacuum degree of the vacuum chamber 40 to meet working requirements of the MEMS device 20. At least one getter structural unit of the getter structure 100 can be activated after completion of encapsulation in the vacuum encapsulation structure 200 for a certain period, absorb gases produced in the vacuum chamber 40 or entering into the vacuum chamber 40, and enable the vacuum degree of the deteriorated vacuum chamber 40 to meet again the working requirements of the MEMS device 20. Activation of the getter thin film 5 can be achieved by transferring electrical energy to the heater 10 via the conductive terminal 32b thereby a temperature of the getter thin film 5 is increased to its activation temperature. At least one getter structural unit performs vacuum encapsulation of the plural getter structural units and the MEMS device 20 simultaneously, then the getter thin film 5 can be activated timely when needed. In this way, compared to the situation in which the getter can only be activated once, the present Embodiment enables the MEMS device 20 to be in a more ideal vacuum environment for a longer time. This means that not only the performance stability and reliability of the MEMS device can be improved, but also a service life of the MEMS device and a vacuum encapsulation structure whole component including the MEMS device can be extended by multiples, so as to reduce the use cost. Moreover, each getter structural unit is provided with the heater 10, thus its getter thin film 5 can be activated for many times. Although after the second activation, the gettering effect of the getter thin film 5 will be less effective than that after the first activation, it still can serve a function of improving the vacuum degree inside the vacuum chamber 40.

As described above, because the encapsulation structure of the MEMS device provided by the present Embodiment contains a tiny heater, the getter structure can be activated at any time when needed, thereby the performance stability and reliability of the MEMS device is improved, a service life of the MEMS device can be also extended, and the use cost is reduced. The heater and the getter thin film are integral, the volume is very small, thus a space of the encapsulation structure of the MEMS device can be saved.

## Claims

1. A thin film getter structure having a miniature heater, comprising:
a substrate (1);
a heater (10) formed at a side of a main face (1a) of the substrate (1); and
a getter thin film (5) formed on a surface of the heater (10),
wherein the heater comprises:
a first insulating thin film (2);
a thin film resistance (3) formed on an upper surface of the first insulating thin film (2); and
a second insulating thin film (4) covering the thin film resistance (3),
both ends (3a, 3b) of the thin film resistance (3) being electrodes exposed from the second insulating thin film (4),
**characterized in that**,
the second insulating thin film comprises a first portion (4a) and a second portion (4b), the first portion (4a) and the second portion (4b) are separated from each other through an isolation groove (4c),
the first portion (4a) covers part of the thin film resistance.

2. The thin film getter structure according to claim 1, wherein,
an area of the getter thin film (5) formed on the first portion (4a) of the second insulating thin film is smaller than an area of the first portion (4a) of the second insulating thin film.

3. The thin film getter structure according to claim 1,
wherein, the thin film getter structure (100) comprises two or more heaters (10) and two or more getter thin films (5),
each of the getter thin films (5) is provided on an upper surface of the corresponding heater (10).

4. The thin film getter structure according to claim 1, wherein,
the main face of the substrate (1) has a cavity (6),
a portion bearing the getter thin film (5), of the heater (10) is located above the cavity (6),
the portion bearing the getter thin film (5), of the heater (10) is supported on the main face surrounding the cavity (6) via a connection part (7).

5. A vacuum encapsulation structure of a micro-electro-mechanical system device, comprising:
a vacuum encapsulation housing (30), a vacuum chamber (40) is formed inside the vacuum encapsulation housing (30);
a micro-electro-mechanical system device (20) encapsulated inside the vacuum encapsulation housing (30);
a conductive terminal (32b), one end thereof being located inside the vacuum encapsulation housing (30), the other end thereof being located outside the vacuum encapsulation housing (30); and
the thin film getter structure (100) according to claim 1, encapsulated inside the vacuum encapsulation housing (30),
wherein, an electrode of the thin film resistance (3) of the thin film getter structure (100) is electrically connected with the conductive terminal (32b).

6. A manufacturing method of a thin film getter structure having a miniature heater, comprising:
forming a heater (10) on a main face (1a) of a substrate (1); and
forming a getter thin film (5) on a surface of the heater (10);
wherein, the step of forming the heater comprises:
forming a first insulating thin film (2) on the main face (1a) of the substrate (1); forming a thin film resistance (3) on an upper surface of the first insulating thin film (2); and
forming a second insulating thin film (4) covering the thin film resistance (3), wherein, both ends (3a, 3b) of the thin film resistance (3) are formed as electrodes exposed from the second insulating thin film (4),
**characterized in that**,
the step of forming the heater further comprises:
forming an isolation groove (4c) in the second insulating thin film (4), the isolation groove separates a first portion (4a) and a second portion (4b) of the second insulating thin film (4) from each other,
wherein, the first portion (4a) covers part of the thin film resistance.

7. The manufacturing method according to claim6, wherein,
an area of the getter thin film (5) formed on the first portion (4a) of the second insulating thin film (4) is smaller than an area of the first portion (4a) of the second insulating thin film (4).

8. The manufacturing method according to claim 6, wherein,
the manufacturing method further comprises:
before the getter thin film (5) is formed on a surface of the heater (10), etching the heater (10) to form a connection part (7) and a part of the heater for bearing the getter thin film (5), and etching the main face (1a) of the substrate (1) to form a cavity (6) under the heater (10), such that the part of the heater (10) for bearing the getter thin film (5) is suspended.

## Patentansprüche

1. Dünnfilm-Getterstruktur mit einer Miniaturheizung, umfassend:
ein Substrat (1);
eine Heizung (10), die an einer Seite einer Hauptfläche (1a) des Substrats (1) gebildet ist; und
einen Getter-Dünnfilm (5), der auf einer Oberfläche der Heizung (10) gebildet ist,
wobei die Heizung umfasst:
einen ersten isolierenden Dünnfilm (2);
einen Dünnfilm-Widerstand (3), der auf einer oberen Oberfläche des ersten isolierenden Dünnfilms (2) gebildet ist; und
einen zweiten isolierenden Dünnfilm (4), der den Dünnfilm-Widerstand (3) bedeckt,
wobei beide Enden (3a, 3b) des Dünnfilm-Widerstands (3) Elektroden sind, die von dem zweiten isolierenden Dünnfilm (4) freigelegt sind,
**dadurch gekennzeichnet, dass**
der zweite isolierende Dünnfilm einen ersten Abschnitt (4a) und einen zweiten Abschnitt (4b) umfasst, wobei der erste Abschnitt (4a) und der zweite Abschnitt (4b) durch eine Isolationsnut (4c) voneinander getrennt sind,
wobei der erste Abschnitt (4a) einen Teil des Dünnfilm-Widerstands bedeckt.

2. Dünnfilm-Getterstruktur nach Anspruch 1, wobei
eine Fläche des Getter-Dünnfilms (5), die auf dem ersten Abschnitt (4a) des zweiten isolierenden Dünnfilms gebildet ist, kleiner ist als eine Fläche des ersten Abschnitts (4a) des zweiten isolierenden Dünnfilms.

3. Dünnfilm-Getterstruktur nach Anspruch 1,
wobei die Dünnfilm-Getterstruktur (100) zwei oder mehr Heizungen (10) und zwei oder mehr Getter-Dünnfilme (5) umfasst,
wobei jeder der Getter-Dünnfilme (5) auf einer oberen Oberfläche der entsprechenden Heizung (10) bereitgestellt ist.

4. Dünnfilm-Getterstruktur nach Anspruch 1, wobei
die Hauptfläche des Substrats (1) einen Hohlraum (6) aufweist,
wobei ein Abschnitt der Heizung (10), der den Getter-Dünnfilm (5) trägt, sich oberhalb des Hohlraums (6) befindet,
wobei der Abschnitt der Heizung (10), der den Dünnfilm (5) trägt, auf der Hauptfläche, die von dem Hohlraum (6) umgeben ist, mittels eines Verbindungsteils (7) gestützt wird.

5. Vakuumkapselungsstruktur einer mikroelektromechanischen Systemvorrichtung, umfassend:
ein Vakuumkapselungsgehäuse (30), wobei innerhalb des Vakuumkapselungsgehäuses (30) eine Vakuumkammer (40) gebildet ist;
eine mikroelektromechanische Systemvorrichtung (20), die innerhalb des Vakuumkapselungsgehäuses (30) gekapselt ist;
einen leitfähigen Anschluss (32b), von dem sich ein Ende innerhalb des Vakuumkapselungsgehäuses (30) befindet, wobei das andere Ende sich außerhalb des Vakuumkapselungsgehäuses (30) befindet; und
die Dünnfilm-Getterstruktur (100) nach Anspruch 1, die innerhalb des Vakuumkapselungsgehäuses (30) gekapselt ist,
wobei eine Elektrode des Dünnfilm-Widerstands (3) der Dünnfilm-Getterstruktur (100) mit dem leitfähigen Anschluss (32b) elektrisch verbunden ist.

6. Herstellungsverfahren einer Dünnfilm-Getterstruktur mit einer Miniaturheizung, umfassend:
Bilden einer Heizung (10) auf einer Hauptfläche (1a) des Substrats (1); und
Bilden eines Getter-Dünnfilms (5) auf einer Oberfläche der Heizung (10);
wobei der Schritt des Bildens der Heizung umfasst:
Bilden eines ersten isolierenden Dünnfilms (2) auf der Hauptfläche (1a) des Substrats (1);
Bilden eines Dünnfilm-Widerstands (3) auf einer oberen Oberfläche des ersten isolierenden Dünnfilms (2); und
Bilden eines zweiten isolierenden Dünnfilms (4), der den Dünnfilm-Widerstand (3) bedeckt,
wobei beide Enden (3a, 3b) des Dünnfilm-Widerstands (3) als Elektroden gebildet sind, die von dem zweiten isolierenden Dünnfilm (4) freigelegt sind,
**dadurch gekennzeichnet, dass**
der Schritt des Bildens der Heizung ferner umfasst:
Bilden einer Isolationsnut (4c) in dem zweiten isolierenden Dünnfilm (4), wobei die Isolationsnut einen ersten Abschnitt (4a) und einen zweiten Abschnitt (4b) des zweiten isolierenden Dünnfilms (4) voneinander trennt,
wobei der erste Abschnitt (4a) einen Teil des Dünnfilm-Widerstands bedeckt.

7. Herstellungsverfahren nach Anspruch 6, wobei
eine Fläche des Getter-Dünnfilms (5), die auf dem ersten Abschnitt (4a) des zweiten isolierenden Dünnfilms gebildet ist, kleiner ist als eine Fläche des ersten Abschnitts (4a) des zweiten isolierenden Dünnfilms (4).

8. Herstellungsverfahren nach Anspruch 6, wobei
das Herstellungsverfahren ferner umfasst:
bevor der Getter-Dünnfilm (5) auf einer Oberfläche der Heizung (10) gebildet wird, Ätzen der Heizung (10), um einen Verbindungsteil (7) und einen Teil der Heizung zum Tragen des Getter-Dünnfilms (5) zu bilden, und Ätzen der Hauptfläche (1a) des Substrats (1), um einen Hohlraum (6) unter der Heizung (10) derart zu bilden, dass der Teil der Heizung (10) zum Tragen des Getter-Dünnfilms (5) aufgehängt ist.

## Revendications

1. Structure à film mince de getter ayant un élément de chauffage miniature, comprenant :
un substrat (1) ;
un élément de chauffage (10) formé sur un côté d'une face principale (1a) du substrat (1) ; et
un film mince de getter (5) formé sur une surface de l'élément de chauffage (10),
dans laquelle l'élément de chauffage comprend :
un premier film mince isolant (2) ;
une résistance à film mince (3) formée sur une surface supérieure du premier film mince isolant (2) ; et
un deuxième film mince isolant (4) recouvrant la résistance à film mince (3),
les deux extrémités (3a, 3b) de la résistance à film mince (3) étant des électrodes exposées à partir du deuxième film mince isolant (4),
**caractérisée en ce que**,
le deuxième film mince isolant comprend une première portion (4a) et une deuxième portion (4b), la première portion (4a) et la deuxième portion (4b) sont séparées l'une de l'autre par une rainure d'isolation (4c),
la première portion (4a) recouvre en partie la résistance à film mince.

2. Structure à film mince de getter selon la revendication 1, dans laquelle,
une aire du film mince de getter (5) formé sur la première portion (4a) du deuxième film mince isolant est plus petite qu'une aire de la première portion (4a) du deuxième film mince isolant.

3. Structure à film mince de getter selon la revendication 1,
dans laquelle la structure à film mince de getter (100) comprend deux ou plus éléments de chauffage (10) et deux ou plus films minces de getter (5),
chacun des films minces de getter (5) est prévu sur une surface supérieure de l'élément de chauffage (10) correspondant.

4. Structure à film mince de getter selon la revendication 1, dans laquelle,
la face principale du substrat (1) a une cavité (6),
une portion portant le film mince de getter (5), de l'élément de chauffage (10) est située au-dessus de la cavité (6),
la portion portant le film mince de getter (5), de l'élément de chauffage (10) est supportée sur la face principale entourant la cavité (6) par l'intermédiaire d'une partie de connexion (7).

5. Structure d'encapsulation sous vide d'un dispositif de système micro-électromécanique, comprenant :
un logement d'encapsulation sous vide (30), une chambre de vide (40) est formée à l'intérieur du logement d'encapsulation sous vide (30) ;
un dispositif de système micro-électromécanique (20) encapsulé à l'intérieur du logement d'encapsulation sous vide (30) ;
une borne conductrice (32b), dont une extrémité est située à l'intérieur du logement d'encapsulation sous vide (30), l'autre extrémité est située à l'extérieur du logement d'encapsulation sous vide (30) ; et
la structure à film mince de getter (100) selon la revendication 1, encapsulée à l'intérieur du logement d'encapsulation sous vide (30),
dans laquelle une électrode de la résistance à film mince (3) de la structure à film mince de getter (100) est connectée électriquement à la borne conductrice (32b).

6. Procédé de fabrication d'une structure à film mince de getter ayant un élément de chauffage miniature, comprenant :
la formation d'un élément de chauffage (10) sur une face principale (1a) d'un substrat (1) ; et
la formation d'un film mince de getter (5) sur une surface de l'élément de chauffage (10) ;
dans lequel l'étape de formation de l'élément de chauffage comprend :
la formation d'un premier film mince isolant (2) sur la face principale (1a) du substrat (1) ;
la formation d'une résistance à film mince (3) sur une surface supérieure du premier film mince isolant (2) ; et
la formation d'un deuxième film mince isolant (4) recouvrant la résistance à film mince (3),
dans lequel, les deux extrémités (3a, 3b) de la résistance à film mince (3) sont formées comme des électrodes exposées à partir du deuxième film mince isolant (4),
**caractérisé en ce que**,
l'étape de formation de l'élément de chauffage comprend en outre :
la formation d'une rainure d'isolation (4c) dans le deuxième film mince isolant (4), la rainure d'isolation sépare l'une de l'autre une première portion (4a) et une deuxième portion (4b) du deuxième film mince isolant (4),
dans lequel, la première portion (4a) recouvre en partie la résistance à film mince.

7. Procédé de fabrication selon la revendication 6, dans lequel,
une aire du film mince de getter (5) formé sur la première portion (4a) du deuxième film mince isolant (4) est plus petite qu'une aire de la première portion (4a) du deuxième film mince isolant (4).

8. Procédé de fabrication selon la revendication 6, dans lequel,
le procédé de fabrication comprend en outre :
avant la formation du film mince de getter (5) sur une surface de l'élément de chauffage (10), la gravure de l'élément de chauffage (10) pour former une partie de connexion (7) et une partie de l'élément de chauffage destinée à porter le film mince de getter (5), et la gravure de la face principale (1a) du substrat (1) pour former une cavité (6) sous l'élément de chauffage (10), de telle sorte que la partie de l'élément de chauffage (10) destinée à porter le film mince de getter (5) est suspendue.
